# EUROPEAN PATENT APPLICATION

(11) **EP 2 528 111 A2**
(43) Date of publication of application: **28.11.2012**
(21) Application number: 11190315.9
(22) Date of filing: 23.11.2011
(51) Int. Cl.: H01L 31/09, H01L 31/0224, H01L 31/0352, G01J 5/20

(54) **Structure for temperature sensors and infrared detectors in the form of thermal detectors**

(30) Priority: 23.05.2011 SE 1150478
(71) Applicant: Acreo AB, 164 40 Kista (SE)
(72) Inventor: Ericsson, Per, 175 67 JÄRFÄLLA (SE)
(74) Representative: Haag, Malina Anna

(57) **Abstract**

Structure for temperature sensors and infrared detectors in the form of thermal detectors arranged on a substrate (2) comprising a thermistor layer (3), the resistance of which is temperature dependent, and comprising one electric contact layer (4,5) on both respective sides of the thermistor layer (3), between which contact layers the resistance is to be measured, wherein the thermistor layer (3) is constituted by a monocrystalline quantum well structure comprising alternating quantum well layers and barrier layers, wherein the substrate (2) is constituted by a sheet of silicon, wherein the quantum well layers are of silicon germanium, SiGe, and wherein the barrier layers are of non-doped or low-doped silicon, Si, and wherein between both said contact layers (4,5) and the thermistor layer (3) there is arranged a buffer layer (8,9) of silicon, Si, arranged to prevent the contact layers (4,5) to overfill the quantum wells in the thermistor layer (3).
The invention is **characterised in that** the contact layers (4,5) are p-doped and in that the quantum well structure is n-doped or non-doped, and in that the buffer layers are n-doped

## Description

The present invention relates to a structure for temperature sensors and infrared detectors in the form of thermal detectors.

In the Swedish patent no. 533 025, a structure for temperature sensors and infrared detectors is described in the form of thermal detectors, arranged on a substrate comprising a thermistor layer the resistance of which is temperature dependent and comprises an electric contact layer on both sides of the thermistor layer, between which contact layers the resistance is to be measured. The thermistor layer is constituted by a monocrystalline quantum well structure comprising alternating quantum well layers and barrier layers. The substrate is often constituted by a sheet of silicon, and the quantum well layers are of silicon germanium, SiGe, which has been p-doped. The barrier layers are of non-doped or low-doped silicon, Si.

The invention according to the said patent is **characterised in that** between both said contact layers and the thermistor layer, there is a buffer layer arranged to prevent the contact layers to overfill the quantum wells in the thermistor layer, and in that the thermistor layer has a number of quantum well layers which is less than 20.

The problem with a structure of this type is that the maximum resistivity across the structure is too low for certain applications.

Hence, in the said patent a solution is described, according to which the quantum well layers are p-doped, and in which the buffer layers are non-doped or low-doped. Since the component builds upon the principle of hole transport, the upper limit for the resistivity is too low. The only way in which the resistivity can be controlled towards higher values is to increase the thickness of the structure. In the application as thermistor in an IR bolometer, there is an absolute upper limit for the thickness of the structure. A combination of relatively low resistivity and demands on a largest thickness result in that the component receives a resistance which is lower than what is desirable.

When the quantum wells are p-doped and the buffer layers are non-doped or low-doped, the resistance decreases relatively little when the p-doping in the buffer layers increases.

The present invention solves the above mentioned problem of low resistivity and offers a structure with higher and selectable resistivity.

Thus, the present invention relates to a structure for temperature sensors and infrared detectors in the form of thermal detectors arranged on a substrate comprising a thermistor layer, the resistance of which is temperature dependent, and comprising one electric contact layer on both respective sides of the thermistor layer, between which contact layers the resistance is to be measured, wherein the thermistor layer is constituted by a monocrystalline quantum well structure comprising alternating quantum well layers and barrier layers, wherein the substrate is constituted by a sheet of silicon, wherein the quantum well layers are of silicon germanium, SiGe, and wherein the barrier layers are of non-doped or low-doped silicon, Si, and wherein between both said contact layers and the thermistor layer there is arranged a buffer layer of silicon, Si, arranged to prevent the contact layers to overfill the quantum wells in the thermistor layer, and is **characterised in that** the contact layers are p-doped and in that the quantum well structure is n-doped or non-doped, and in that the buffer layers are n-doped.

In the following, the invention is more closely described, partly in connection to embodiments shown on the enclosed drawing, where:
- figure 1 shows a structure according to the invention
- figure 2 shows a diagram of the resistance as a function of doping level and the thickness of the buffer layer.

"Quantum well layers" is to be interpreted as thin layers of semiconductor material, so called quantum well layers, in which charge carriers have lower energy than in surrounding layers, so called barrier layers. Quantum well layers and barrier layers are both single crystalline and grating adapted to each other. When the quantum well layers are thin, energy quantization will occur, which affects allowed energy levels of the charge carriers.

For thermistor materials of quantum well type, it is in general true that the temperature coefficient of the detector B = Ea/kT², where Ea is the activation energy, where k is the Boltzmann constant, and where T is the temperature.

The activation energy depends on the energy difference between the valence bands in the barrier and the allowed energy levels in the quantum well. The energy difference is controlled using doping level, well thickness and height of the energy barrier, which locks holes in the well. The broader the well and the lower the doping level, the higher activation energy is achieved, which leads to a higher temperature coefficient. The higher the barrier, the higher the achieved activation energy.

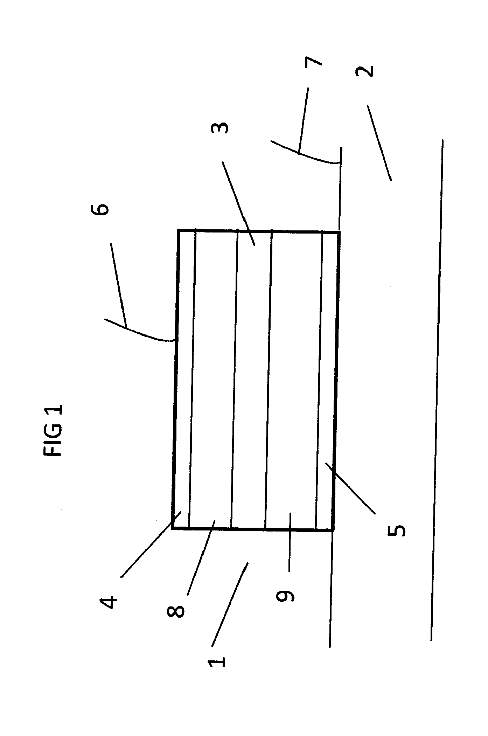

In figure 1, a structure 1 for temperature sensors and infrared detectors are shown, built up on a substrate 2 comprising a thermistor layer 3, the resistance of which is temperature dependent and comprises an electric contact layer 4, 5 on both sides of the thermistor layer 3, between which contact layers the resistance is to be measured. The reference numerals 10, 11 denote electric conductors.

Between both said contact layers 4, 5 and the thermistor layer 3, there are buffer layers 8, 9 arranged to prevent the contact layers 4, 5 to overfill the quantum wells in the thermistor layer 3.

The thermistor layer 3 is constituted by a monocrystalline quantum well structure comprising alternating quantum well layers and barrier layers. The substrate 2 is constituted by a sheet of silicon.

In the thermistor layer 3, the quantum well layers are made of silicon germanium, SiGe, and the barrier layers are constituted by non-doped or low-doped silicon, Si.

According to the present invention, the contact layers 4, 5 are p-doped. Moreover, the quantum well structure is n-doped or non-doped, and the buffer layers are n-doped.

Previously, the inventor was convinced that the buffer layers should be non-doped or low-doped of p-type, and that the quantum wells should be p-doped. Therefore, it was surprising that it was possible for the quantum wells to be n-doped or non-doped at the same time as the buffer layers could be n-doped.

It was also surprising that it is possible, using n-doped quantum wells, to achieve a higher and controllable resistance across the structure as compared to if the quantum wells are p-doped. In other words, n-type doping in both the buffer layer and in the quantum wells gives a great possibility to optimize a structure with respect to both structure resistivity and thickness.

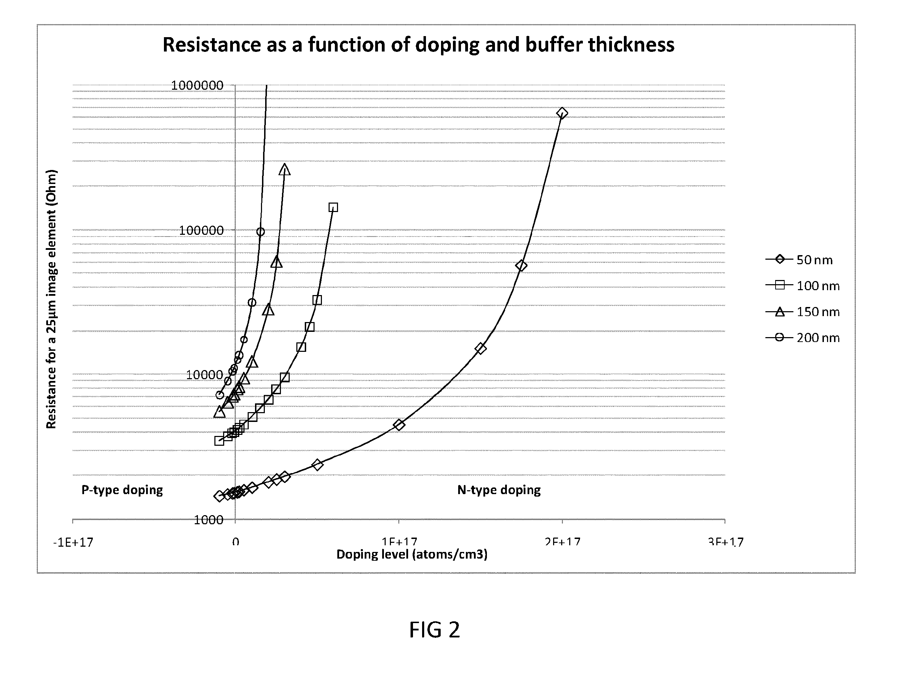

As an example, in figure 2 is shown the resistance for a thermistor with dimensions 25x25 square micrometer as a function of the doping level and thickness of each of the two buffer layers 8, 9. Hence, in figure 2, there are shown four curves for buffer layers with thicknesses 50 nanometers, 100 nanometers, 150 nanometers and 200 nanometers.

On the x axis, doping level (atoms/cm³) is denoted, and on the y axis, the resistance across the structure 1 is denoted in Ohms. On the x axis, "-1E+17" means -1×10¹⁷, and "2E+17" means 2x10¹⁷.

As is clear from figure 2, a doping of p-type, which thus is to the left of the line "0", results in a resistance which is substantially lower than when the doping is of n-type. Furthermore, it is clear that the resistance increases more rapidly for a certain doping level the thicker the buffer layer is.

By selecting a combination of thickness of the buffer layers 8, 9 and the doping level in the same, the resistance can thus be selected from a broad interval.

According to a preferred embodiment, the contact layers 4, 5 are p-doped, the quantum well structure is n-doped and the buffer layers 8, 9 are n-doped.

According to another preferred embodiment, the resistance across the structure 1 is chosen by selecting the doping level of the quantum well layers 3 and the buffer layers 8, 9 at a chosen thickness of the quantum well structure and the buffer layers.

In addition, it is preferred that the doping of the buffer layers is more than 1x10¹⁶ cm⁻³, but less than 2x10¹⁷ cm⁻³.

Moreover, it is preferred that the doping of the quantum well layers is more than 1x10¹⁶ cm⁻³, but less than 2x10¹⁷ cm⁻³.

Furthermore, it is preferred that the combination of the total thickness (t) of the quantum well structure 3, the buffer layers 8, 9 and the doping level results in a resistance across the structure 1 which exceeds 30 kOhm.

According to a preferred embodiment, the thermistor layer 3 has a number of quantum well layers which is less than 20.

It is apparent that the present invention results in that the structure 1 can be optimized with respect to resistivity and thickness within broad limits.

Above, a number of embodiments have been described. However, the invention may be varied with respect to other doping levels and thicknesses than the ones given in figure 2.

Therefore, the present invention is not to be limited to the above described embodiments, but may be varied within the scope of the enclosed claims.

## Claims

1. Structure for temperature sensors and infrared detectors in the form of thermal detectors arranged on a substrate (2) comprising a thermistor layer (3), the resistance of which is temperature dependent, and comprising one electric contact layer (4,5) on both respective sides of the thermistor layer (3), between which contact layers the resistance is to be measured, wherein the thermistor layer (3) is constituted by a monocrystalline quantum well structure comprising alternating quantum well layers and barrier layers, wherein the substrate (2) is constituted by a sheet of silicon, wherein the quantum well layers are of silicon germanium, SiGe, and wherein the barrier layers are of non-doped or low-doped silicon, Si, and wherein between both said contact layers (4,5) and the thermistor layer (3) there is arranged a buffer layer (8,9) of silicon, Si, arranged to prevent the contact layers (4,5) to overfill the quantum wells in the thermistor layer (3), **characterised in that** the contact layers (4,5) are p-doped and **in that** the quantum well structure is n-doped or non-doped, and **in that** the buffer layers are n-doped.

2. Structure according to claim 1, **characterised in that** the contact layers (4,5) are p-doped, **in that** the quantum well structure is n-doped, and **in that** the buffer layers are n-doped.

3. Structure according to claim 1 or 2, **characterised in that** the resistance across the structure is chosen by selecting the degree of doping of the quantum well layers, and **in that** the buffer layers are selected at a chosen thickness of the quantum well structure and the buffer layers.

4. Structure according to claim 1, 2 or 3, **characterised in that** the doping of the buffer layers is more than 1x10¹⁶ cm⁻³, but less than 2x10¹⁷ cm⁻³.

5. Structure according to claim 1, 2, 3 or 4, **characterised in that** the doping of the quantum well layers is more than 1x10¹⁶ cm⁻³, but less than 2x10¹⁷ cm⁻³.

6. Structure according to claim 1, 2, 3, 4 or 5, **characterised in that** the combination of the total thickness (t) of the quantum well structure, the buffer layers and the degree of doping results in a resistance across the structure which is more than 30 kOmh.

7. Structure according to claim 1, 2, 3, 4, 5 or 6, **characterised in that** the thermistor layer (3) has a number of quantum well layers, which number is less than 20.
